# EUROPEAN PATENT APPLICATION

(11) **EP 1 633 179 A2**
(43) Date of publication of application: **08.03.2006**
(21) Application number: 05107859.0
(22) Date of filing: 26.08.2005
(51) Int. Cl.: H05K 9/00, H01L 23/552

(54) **Electromagnetic wave shielding structure**

(30) Priority: 03.09.2004 KR 2004070438
(71) Applicant: SAMSUNG ELECTRONICS CO., LTD., Suwon-City, Kyungki-do (KR)
(72) Inventor: Byun, Sang-bum, Gyeonggi-do (KR)
(74) Representative: Derry, Paul Stefan

(57) **Abstract**

A displaying apparatus includes a printed circuit board (PCB) (20), an integrated circuit (IC) (30) provided on the PCB, a shield case (40) enclosing the PCB, an electromagnetic wave conducting part (50) interposed between and in contact with the IC (30) and the shield case (40) to conduct electromagnetic waves generated from the IC (30) into the shield case (40), and a grounding part (60) to be in contact with the shield case (40) to by-pass the electromagnetic waves conducted into the shield case (40) through the electromagnetic wave conducting part (50). Thus the displaying apparatus is capable of shielding electromagnetic waves generated from the IC (30) mounted on the PCB (20) simply and efficiently.

## Description

A first aspect of the present invention relates to a unit comprising: an electrical component provided on a printed circuit board; a shield case, arranged to enclose the printed circuit board; and a grounding part in contact with the shield case to conduct electromagnetic waves away from the shield case. A second aspect of the invention relates to a unit comprising: an electrical component provided on a printed circuit board; a shield case, arranged to enclose the printed circuit board; and a grounding part.

The term "displaying apparatus" used in this description refers to various kinds of apparatuses that visually display data on a display panel. The data can be in the form of text or an image.

As a variety of circuit components used in a displaying apparatus have a high capacity and a high integration, electromagnetic interference (EMI) can be generated. EMI causes electromagnetic waves generated by radiated emission (RE) or conducted emission (CE) to interfere with functions of other devices. This can cause deterioration of functions of the circuit and malfunctions in the devices.

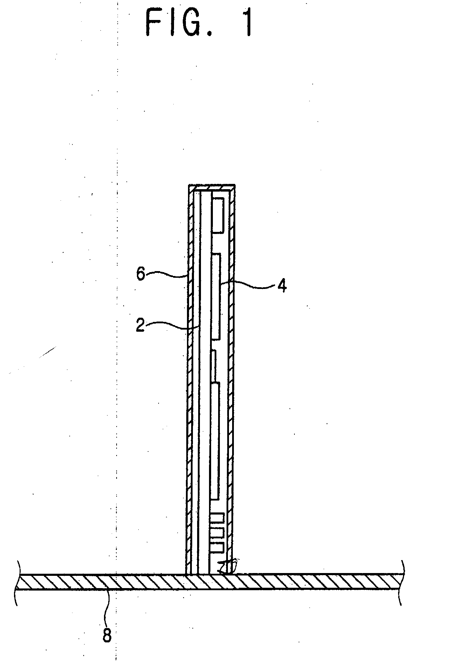

As illustrated in Figure 1, a conventional displaying apparatus comprises a printed circuit board (PCB) 2, an integrated circuit (IC) 4 provided on the PCB 2, a shield case 6 enclosing the PCB 2, and a grounding part 8 that is in contact with the shield case 6 for removing electromagnetic waves. The shield case 6 conducts the electromagnetic waves generated from a variety of circuit components mounted on the PCB 2 to the grounding part 8.

However, when excessive electromagnetic radiation is emitted from the integrated circuit 4, the conventional displaying apparatus cannot completely shield the electromagnetic waves with only the shield case 6, and EMI can occur.

Recently, a connector and an assembly for mounting an IC having a structure connected to the IC, capable of shielding heat generation and electromagnetic waves, to minimize the phenomenon of the EMI from the IC has been disclosed in Japanese First Publication No. 2004-6299. However, they are disadvantageous in that the electromagnetic wave shielding structure is complicated, resulting in poor assembling efficiency and incurring a large production cost.

The embodied structure can provide a displaying apparatus capable of shielding electromagnetic waves generated by an IC mounted on a PCB simply and efficiently.

The first aspect of the invention is characterised by an electromagnetic wave conducting part in contact with the shield case and the electrical component to conduct electromagnetic waves generated by the electrical component to the shield case.

The second aspect of the invention is characterised by an electromagnetic wave conducting part in contact with the shield case and with the grounding part to conduct electromagnetic waves from the shield case to the grounding part.

Embodiments of the present invention will now be described with reference to the accompanying drawings of which:
Figure 1 is a sectional view illustrating an electromagnetic wave shielding structure of a conventional displaying apparatus;
Figure 2 is a perspective view illustrating a first embodiment of an electromagnetic wave shielding structure of a displaying apparatus, according to the present invention;
Figure 3 is a sectional view illustrating the electromagnetic wave shielding structure of Figure 2;
Figure 4 is a sectional view illustrating an electromagnetic wave conducting part of the electromagnetic wave shielding structure of Figure 3; and
Figure 5 is a sectional view illustrating a second embodiment of an electromagnetic wave shielding structure of a displaying apparatus, according to the present invention.

In the accompanying drawings, like reference numerals refer to the like elements throughout.

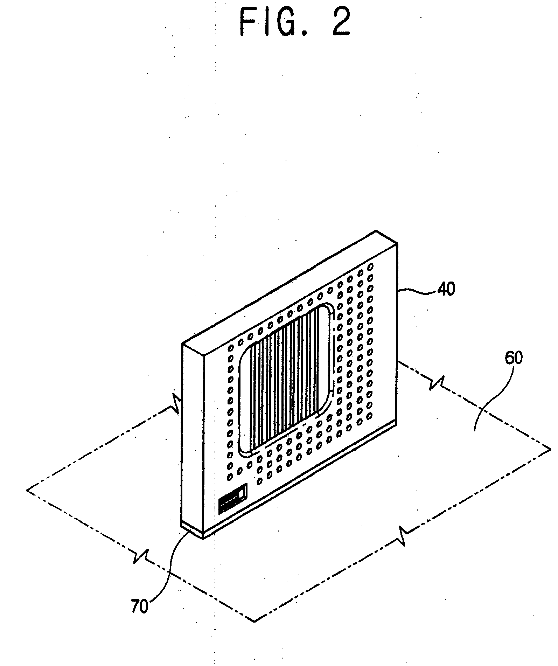

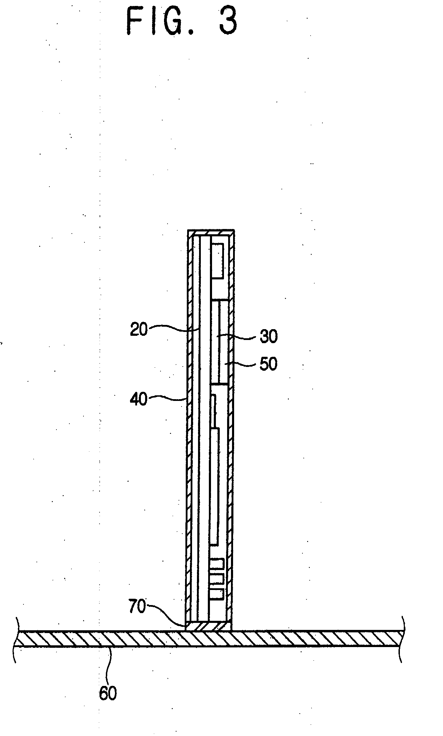

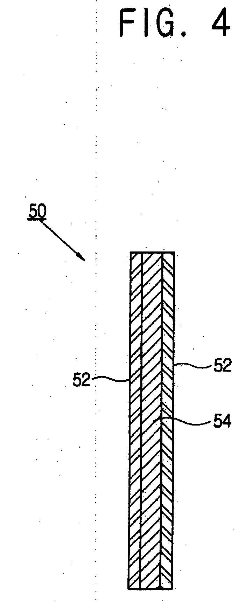

Referring to Figures 2 to 4, a first embodiment of an electromagnetic wave shielding structure of a displaying apparatus comprises a printed circuit board (PCB) 20, an integrated circuit (IC) 30 provided on the PCB, a shield case 40 enclosing the PCB, an electromagnetic wave conducting part 50 interposed between and in contact with the IC 30 and the shield case 40, to conduct electromagnetic waves generated from the IC 30 into the shield case 40. The electromagnetic wave shielding structure also comprises a grounding part 60 to conduct the electromagnetic waves conducted into the shield case 40 through the electromagnetic wave conducting part 50 away from the shield case 40.

A variety of circuit components including the IC 30 can be disposed on the PCB 20.

The IC 30 has a high capacity and a high integration. This can generate excessive electromagnetic radiation. When electromagnetic waves generated by the IC 30 are not properly shielded, significant damage to the circuit components may be caused due to electromagnetic interference (EMI).

The shield case 40 protects the PCB 20 from the outside environment and conducts electromagnetic radiation generated by the various circuit components on the PCB 20 to the grounding part 60.

The electromagnetic wave conducting part 50 can comprise a pair of conductive contact parts 52 in contact with the IC 30 and the shield case 40 respectively, and aresilient part 54 between the pair of contact parts 52 to force the pair of contact parts 52 to contact the IC 30 and the shield case 40 respectively.

The pair of contact parts 52 enhance the efficiency of shielding the electromagnetic waves by conducting the electromagnetic waves generated by the IC 30 to the shield case 40, and increasing the contact efficiency between the IC 30 and the shield case 40. The contact parts 52 may be formed from any conductive fabric having both conductivity and flexibility. The resilient part 54 may be formed of any material which exerts a force when compressed. For example, the resilient part may comprise a sponge, which exerts a force when compressed and is relatively inexpensive.

Various materials may be used for the pair of contact parts 52 and the elastic part 54, as long as they can increase the electromagnetic wave shielding efficiency.

A conductive body 70 can be provided between the shield case 40 and the grounding part 60 to widen the area in contact with the grounding part 60, and enhance the contact efficiency between the shield case 40 and the grounding part 60 at the same time. The conductive body 70 may have the same structure as the electromagnetic wave conducting part 50, as well as other various structures.

When a problem such as heat generation is caused in the IC 30, a heat generating part (not shown) such as a heat sink can be attached to the IC 30. The electromagnetic wave conducting part 50 can then be connected to the heat generating part, to allow the heat generating part to contact the shield case 40 through the electromagnetic wave conducting part 50.

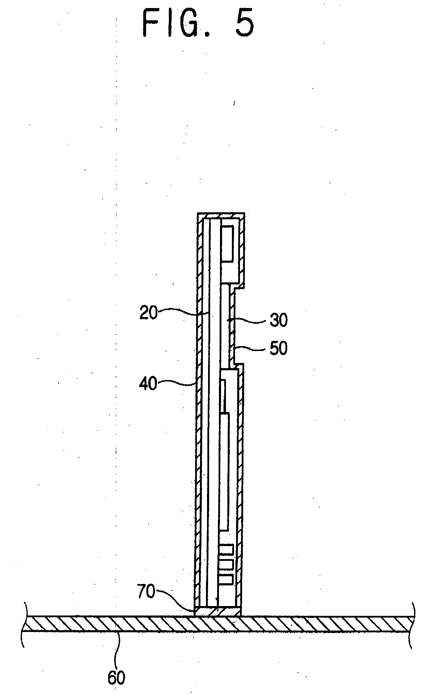

Figure 5 is a sectional view illustrating a second embodiment of an electromagnetic wave shielding structure of a displaying apparatus. Referring to Figure 5, the electromagnetic wave shielding structure is substantially similar to the electromagnetic wave shielding structure of Figures 2 to 4, except that the electromagnetic wave conducting part 50 is projecting inward from the shield case 40 and directly contacts the IC 30 on the PCB 20.

The electromagnetic wave conducting part 50 can be formed integrally with or separately from the shield case 40 to improve productivity and economical efficiency.

For example, when the electromagnetic wave conducting part 50 is formed integrally with the shield case 40, it is possible that the shield case 40 and the electromagnetic wave conducting part 50 can be formed at the same time by use of a press processing.

The electromagnetic wave conducting part 50 may be modified, as long as the IC 30 and the shield case 40 are in contact with each other through the electromagnetic wave conducting part 50.

The shield case 40 may comprise an opening, and the conductive part 50 can be disposed in the opening to be in contact with a portion of the PCB 20, the shield case 40, and the grounding part 50.

As described above, a displaying apparatus according to the present invention can prevent EMI from being generated by an IC mounted on a PCB, to thereby improve the functionality and practicability of the displaying apparatus.

Although a few embodiments of the present general inventive concept have been shown and described, it will be appreciated by those skilled in the art that changes may be made in these embodiments without departing from the principles of the general inventive concept, the scope of which is defined in the appended claims.

## Claims

1. A unit comprising:
an electrical component (30) provided on a printed circuit board (20);
a shield case (40), arranged to enclose the printed circuit board (20); and
a grounding part (60) in contact with the shield case (40) to conduct electromagnetic waves away from the shield case (40),
**characterised by** an electromagnetic wave conducting part (50) in contact with the shield case (40) and the electrical component (30) to conduct electromagnetic waves generated by the electrical component (30) to the shield case (40).

2. A unit as claimed in claim 1 wherein the electromagnetic wave conducting part (50) comprises two conductive parts (52) separated by a resilient part (54), wherein the resilient part (54) is arranged to apply an expansive force to the conducting parts (52).

3. A unit as claimed in any preceding claim, wherein the electromagnetic wave conducting part (50) projects inwards from the shield case (40).

4. A unit as claimed in any preceding claim, further comprising a conductive body (70) between the shield case (40) and the grounding part (60) to conduct electromagnetic waves from the shield case (40) to the grounding part (60).

5. A unit comprising:
an electrical component (30) provided on a printed circuit board (20);
a shield case (40), arranged to enclose the printed circuit board (20); and
a grounding part (60),
**characterised by** an electromagnetic wave conducting part (70) in contact with the shield case (40) and with the grounding part (60) to conduct electromagnetic waves from the shield case (40) to the grounding part (60).

6. A displaying apparatus, comprising:
a printed circuit board (PCB) (20);
an integrated circuit (IC) (30) provided on the PCB (20);
a shield case (40) to enclose the PCB (20);
an electromagnetic wave conducting part (50) interposed between and in contact with the IC (30) and the shield case (40) to conduct electromagnetic waves generated from the IC (30) into the shield case (40); and
a grounding part (60) in contact with the shield case (40) to remove the electromagnetic waves conducted into the shield case (40) through the electromagnetic wave conducting part (50).

7. The displaying apparatus according to claim 6, wherein the electromagnetic wave conducting part (50) comprises:
a pair of conductive contact parts (52) in contact with the IC (30) and the shield case (40), respectively; and
an elastic part (54) interposed between the pair of conductive contact parts (52) to elastically keep the pair of conductive contact parts in contact with the IC and the shield case, respectively.

8. The displaying apparatus according to claim 7, wherein each of the pair of conductive contact parts (52) comprises a conductive fabric.

9. The displaying apparatus according to claim 6, wherein the electromagnetic wave conducting part (50) is projecting inward from the shield case (40).

10. The displaying apparatus according to claim 9, wherein the electromagnetic wave conducting part (50) is integrally formed with the shield case (40).

11. The displaying apparatus according to claim 6, further comprising:
a conductive body (70) provided between the shield case (40) and the grounding part (60) to conduct the electromagnetic waves in the shield case (40) into the grounding part (60).

12. A displaying apparatus comprising:
a shielding unit having a printed circuit board (PCB) (20), an electrical component (30) mounted on a surface of the PCB (20) and generating electromagnetic waves, a shield case (40) to enclose the PCB (20) and the electrical component (30), a grounding part (60) connected to the shield case (40) to remove the electromagnetic waves conducted into the shield case (40), and a conductive part (60) formed on the shield case to be in contact with at least one of the PCB (20) and the electrical component (30).

13. The displaying apparatus according to claim 12, wherein the conductive part is disposed between the shield case (40) and the grounding part (60).

14. The displaying apparatus according to claim 12, wherein the shield case (40) comprises an opening, and the conductive part (50) is disposed in the opening to be in contact with a portion of the PCB (20), the shield case (40), and the grounding part (60).

15. The displaying apparatus according to claim 12, wherein the conductive part (50) comprises a first conductive part (70) disposed between the shield case and the grounding part, and a second conductive part (50) disposed between the electrical component and the shield case.

16. The displaying apparatus according to claim 12, wherein the shield case (40) comprises a plate spaced apart from the PCB (20) by a first distance, and the conductive part (50) is projecting inward from the plate toward PCB (20) and spaced apart from the surface of the PCB (20) by a second distance.

17. The displaying apparatus according to claim 16, wherein the plate of the shield case (40) is substantially parallel to the surface of the PCB.

18. The displaying apparatus according to claim 16, wherein the conductive part (50) is in contact with the electrical component (30).

19. The displaying apparatus according to claim 16, wherein the first distance is greater than the second distance.

20. The displaying apparatus according to claim 16, wherein the electrical component has a second surface facing the plate of the shield case (40), and the second surface is in contact with the conductive part (50) of the shield case.

21. The displaying apparatus according to claim 20, wherein the second surface is substantially parallel to the conductive part (50).

22. The displaying apparatus according to claim 12, wherein the conductive part (50) is disposed between the shield case (40) and the electrical component (30) to conduct the electromagnetic waves into the shield case (40).

23. The displaying apparatus according to claim 22, wherein the conductive part (50) comprises one or more conductive contact part (52) and an elastic part (54).

24. The displaying case according to claim 12, wherein the conductive part (70) is mounted on the grounding part (60), and the shield case (40) is mounted on the conductive part (70).

25. A shielding unit usable with a displaying apparatus, comprising:
a PCB (20);
an electrical component (30) mounted on a surface of the PCB (20) and generating electromagnetic waves;
a shield case (40) to enclose the PCB (20) and the electrical component (30);
a grounding part (60) connected to the shield case (40) to remove the electromagnetic waves conducted into the shield case (40); and
a conductive part (50) formed on the shield case (40) to be in contact with at least one of the PCB (20) and the electrical component (30).
